(19) **Europäisches Patentamt / European Patent Office / Office européen des brevets**

(11) **EP 1 941 288 B1**

(12) **EUROPÄISCHE PATENTSCHRIFT**

(45) Veröffentlichungstag und Bekanntmachung des Hinweises auf die Patenterteilung:
**24.03.2010 Patentblatt 2010/12**

(51) Int Cl.:
***G01R 31/36*** (2006.01)

(21) Anmeldenummer: **06742354.1**

(22) Anmeldetag: **17.05.2006**

(86) Internationale Anmeldenummer:
**PCT/DE2006/000846**

(87) Internationale Veröffentlichungsnummer:
**WO 2007/048366 (03.05.2007 Gazette 2007/18)**

(54) **VERFAHREN UND VORRICHTUNG ZUR STEUERUNG DES ARBEITSPUNKTES EINER BATTERIE**

METHOD AND DEVICE FOR CONTROLLING THE OPERATING POINT OF A BATTERY

PROCEDE ET DISPOSITIF POUR COMMANDER LE POINT DE FONCTIONNEMENT D'UNE BATTERIE

(84) Benannte Vertragsstaaten:
**DE FR IT**

(30) Priorität: **28.10.2005 DE 102005052868**

(43) Veröffentlichungstag der Anmeldung:
**09.07.2008 Patentblatt 2008/28**

(73) Patentinhaber: **TEMIC Automotive Electric Motors GmbH**
**10553 Berlin (DE)**

(72) Erfinder:
- **BIRKE, Peter**
  **16548 Glienicke/Nordbahn (DE)**
- **MALIK, Manfred**
  **82377 Penzberg (DE)**
- **KELLER, Michael**
  **76534 Baden-Baden (DE)**

(56) Entgegenhaltungen:
**EP-A- 1 324 062        US-A- 5 565 759**
**US-A1- 2002 030 495**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren und eine Vorrichtung zur Steuerung des Arbeitspunktes einer, insbesondere sekundären Batterie für ein Fahrzeug, insbesondere zum selbsttätigen Einstellen des Arbeitspunktes. Unter einer sekundären Batterie wird gegenüber einer nicht wieder aufladbaren primären Batterie ein wieder aufladbarer Speicher (auch Akkumulator oder Sekundärspeicher genannt) verstanden. Im Folgenden ist mit Batterie stets eine sekundäre Batterie gemeint. Als Fahrzeugbatterie wird insbesondere eine Nickel-Metall-Hydrid-Batterie, eine Lithium-Ionen-Batterie, eine Blei-Batterie oder eine Lithium-Polymer-Batterie oder eine andere geeignete wieder aufladbare Speichereinheit verwendet. Unter dem Arbeitspunkt der Batterie wird dabei insbesondere die Einstellung des Ladezustands der Batterie verstanden, bei welchem eine optimale, d.h. lebensverlängernde und maximale, Einspeisung oder Entnahme von Leistung möglich ist.

An eine Fahrzeugbatterie werden heute aufgrund der zunehmenden Anzahl an elektrischen Systemen und dem Hinzufügen von Systemen, die auch im abgeschalteten Zustand des Fahrzeugs eine Versorgung benötigen, immer höhere Anforderungen gestellt. So erfordern Dieselmotoren hohe Ströme, insbesondere bei tiefen Temperaturen (hohe Kaltstartleistung) und Fahrzeuge mit elektrischen Ausrüstungen, wie z. B. elektrohydraulische Bremssysteme, aus sicherheitstechnischen Gründen eine ständige Batterieverfügbarkeit.

Dabei ist die Kapazität, d.h. die unter bestimmten Bedingungen entnehmbare Strommenge, stark von nicht-elektrischen Parametern wie Umgebungstemperatur, Zellentemperatur, Alter, abhängig. Von besonderer Bedeutung ist das stark temperaturabhängige Verhalten einer Batterie. So hängen beispielsweise die Kapazität und der Ladezustand einer Nickel-Metall-Hydrid-Batterie (kurz auch NiMH-Batterie genannt) aufgrund der in der negativen Elektrode eingesetzten Wasserstoffspeicherlegierung stark von der Umgebungstemperatur ab. Es wird bei tiefen Temperaturen Wasserstoff mit einer schlechteren Aus- und Einbaukinetik von der negativen Elektrode abgegeben und aufgenommen. Bei höheren Temperaturen werden die Wasserstoffaufnahme und damit die Ladefähigkeit durch die negative Elektrode zusehends beeinträchtigt, da mit steigender Temperatur ein Wasserstoffgegendruck aufgebaut wird. Diese temperaturabhängigen Effekte treten insbesondere bei modernen Metallhydridspeichern (auch "Wassserstofftanks" bezeichnet) auf, bei denen Wasserstoff bei Raumtemperatur gut in einer Wasserstoffspeicherlegierung gebunden, aber durch Wärme wieder ausgetrieben wird. Hierdurch ist die Kapazität und somit die Entnahme begrenzt.

Darüber hinaus ist die Kapazität, d.h. die entnehmbare Ladung oder Strommenge, stark abhängig vom Ladezustand der Batterie. Moderne Batterien, wie Nickel-Metall-Hydrid-Batterien oder Lithium-Ionen-Batterien weisen eine hohe Leistungsdichte von bis zu 1,8 kW/kg bzw. 3 kW/kg auf, so dass eine hohe Entnahme und gute Ladefähigkeit bei niedrigen Temperaturen bereits teilweise ermöglicht ist.

Um die verschiedenen elektrischen Funktionen des Fahrzeugs, z. B. Startfunktionen oder Sicherheitsfunktionen während des Fahrens, aufrechterhalten zu können, wird üblicherweise die Batterieverfügbarkeit fortlaufend überwacht. Hierzu ist es bekannt, den Batteriezustand, z. B. den Ladezustand, die Kapazität und/oder die Alterung der Batterie, zu erfassen und daraus die aktuelle Leistungsfähigkeit der Batterie zu bestimmen. Dabei basieren derartige Verfahren im Allgemeinen auf aufwendigen Strom- und Spannungsmessverfahren oder auf erfahrungsbasierten aufwendigen Modellrechnungen.

So ist es aus der DE 199 18 529 B4 bekannt, den Ladezustand und/oder die Kapazität einer Batterie anhand einer Messung des Batteriestroms und einer Ermittlung einer gemessenen entnommenen Ladung aus dem zeitlichen Verlauf des Batteriestroms unter Berücksichtigung der Ruhespannung der Batterie zu bestimmen.

Die bekannten Verfahren ermöglichen dabei die Bestimmung der entnehmbaren Ladung (= Entladen) und der Ladefähigkeit (= Laden) der Batterie in ihrem Kapazitätsbereich anhand der Strom- und Spannungsmessung und unter Berücksichtigung des Ladezustands der Batterie. So ist eine Nickel-Metall-Hydrid-Batterie in der Lage, aufgrund der hohen Leistungsdichte in einem Kapazitätsbereich von 30 % bis 70 % mit voller Ladeund Endladeleistung zu arbeiten. Hat die Batterie einen Ladezustand von 90 % erreicht, so wird das Laden stark begrenzt, da es ansonsten zu einem schädlichen Überladen der Batterie kommen kann, welche zu einer deutlichen Reduzierung der Gebrauchsdauer der Batterie führen könnte.

Aus Dokument EP 1 324 062 A2 ist ein Verfahren zur Ermittlung des Betriebszustands einer Speicherbatterie bei angenommenen Temperatur- und Ladezustandsbedingungen bekannt.

Der Erfindung liegt die Aufgabe zugrunde, ein Verfahren zur Steuerung des Arbeitspunktes einer Batterie anzugeben, so dass eine optimale Ausnutzung des Kapazitätsbereichs der Batterie ermöglicht wird. Darüber hinaus ist eine besonders geeignete Vorrichtung anzugeben.

Die Aufgabe wird erfindungsgemäß gelöst durch die Merkmale des Anspruchs 1. Hinsichtlich der Vorrichtung wird die Aufgabe erfindungsgemäß gelöst durch die Merkmale des Anspruchs 12.

Vorteilhafte Weiterbildungen der Erfindung sind Gegenstand der Unteransprüche.

Erfindungsgemäß wird beim Verfahren zur Steuerung des Arbeitspunktes einer Batterie, insbesondere einer Lithium-Ionen-Batterie, einer Nickel-Metall-Hydrid-Batterie; einer Lithium-Polymer-Batterie, als eine den Arbeitspunkt der Batterie bestimmenden Zustandsgröße der aktuelle Ladezustand der Batterie erfasst, wobei der aktuelle Arbeitspunkt mittels eines zugehörigen, in Abhängigkeit von der Temperatur und/oder vom Alterungszustand der Batterie fortlaufend angepassten Sollwerts für den Ladezustand eingestellt wird. Eine derartige temperatur-und/oder alterungsabhängige Nachführung des vorgegebenen Sollwerts für den Ladezustand der Batterie ermöglicht eine dynamische Einstellung des Arbeitspunktes der Batterie, wodurch die Lebens- und Betriebsdauer der Batterie deutlich verlängert werden kann. Zudem wird die Batterie für einen elektrischen Antrieb bei einem Hybridfahrzeug hinsichtlich verfügbarer Zeit und entnehmbarer Leistung optimiert.

Zweckmäßigerweise wird der aktuelle Sollwert für den Ladezustand anhand einer vorgegebenen ersten Kennlinie, insbesondere einer Sollwert-Temperatur-Kennlinie angepasst gemäß folgender Beziehung:

$$SoC_{AP} = SoC_{soll}(T) \qquad\qquad [1]$$

mit $SoC_{AP}$ = Ladezustandswert im Arbeitspunkt, $SoC_{soll}(T)$ = Sollwert für den Ladezustand in Abhängigkeit von der Temperatur T.

Mit anderen Worten: Der Sollwert für den Ladezustand wird temperaturabhängig fortlaufend nachgeführt. Hierdurch sind temperaturabhängige negative Effekte, wie z. B. ein zu niedriger Ladezustand bei niedrigen Temperaturen oder ein zu hoher Ladezustand bei hohen Temperaturen, ausgleichbar, indem der Sollwert für den Ladezustand anhand der Temperatur-Kennlinie angepasst wird. Dabei wird bei niedrigen Temperaturen und niedrigem Ladezustand Leistung gegebenenfalls zugeführt, um einen zu erwartenden Spannungseinbruch zu kompensieren. Demgegenüber wird bei hohen Temperaturen und hohem Ladezustand die Batterie gegebenenfalls entladen, um den Wasserstoffgegendruck zu kompensieren.

Dabei wird der aktuelle Ladezustand der Batterie beispielsweise anhand von herkömmlichen Messverfahren, insbesondere anhand einer kontinuierlichen Messung des Batteriestroms und der aufgenommenen und/oder entnommenen Ladung, z. B. mittels eines Ah-Zählers (Ah = Amperestunden, ermittelt. Bei einem anderen Verfahren kann der aktuelle Ladezustand anhand eines Ruhespannungsmessverfahrens bestimmt werden.

Die Temperatur-Kennlinie zur Bestimmung des aktuellen Sollwerts für den Ladezustands berücksichtigt dabei als Temperatur insbesondere die Umgebungstemperatur. Je nach Grad der Genauigkeit des Verfahrens können weitere zusätzliche Temperaturparameter, wie z. B. die Batterietemperatur, insbesondere die Zellentemperatur, erfasst und berücksichtigt werden.

Darüber hinaus hängt die verfügbare Kapazität einer Batterie maßgeblich von ihrem Alterungszustand ab. Zusätzlich oder alternativ kann daher der aktuelle Sollwert für den Ladezustand mittels eines alterungsabhängigen Korrekturfaktors und anhand einer vorgegebenen zweiten, insbesondere alterungsabhängigen Kennlinie für den Korrekturfaktor angepasst und nachgeführt werden. Die alterungsabhängige Kennlinie beinhaltet einen Korrekturfaktor für den Ladezustand in Abhängigkeit vom Alterungszustand der Batterie. Dabei dient der alterungsabhängige Korrekturfaktor zur Korrektur des Sollwerts oder alternativ des Istwerts für den Ladezustand und somit zum Einstellen des Arbeitspunktes der Batterie dienen gemäß folgender Beziehungen:

$$SoC_{AP} = SoC_{soll}(T) * SoC_{korr} \qquad\qquad [2.1]$$

$$SoC_{AP} = SoC_{soll}(T) * SoC_{soll}/SoC_{ist} \qquad\qquad [2.2]$$

mit $SoC_{AP}$ = Ladezustandswert im Arbeitspunkt, $SoC_{soll}(T)$ = Sollwert für den Ladezustand in Abhängigkeit von der Temperatur T und gemessen bei Temperatur von $SoC_{ist}$, $SoC_{korr}$ = alterungsabhängiger Korrekturfaktor, $SoC_{ist}$ = Temperaturistwert.

Mit anderen Worten: Der aktuelle Ladezustand oder der Arbeitspunkt der Batterie kann anhand eines alterungsabhängigen Korrekturfaktors mittels einer zugehörigen zweiten Kennlinie nachgeführt werden. Eine solche Nachführung ist aufgrund reversibler wie auch irreversibler elektrochemischer Betriebs und Alterungsvorgänge der Batterie erforderlich.

Die temperaturabhängige bzw. die alterungsabhängige Einstellung des Arbeitspunktes kann kombiniert oder alternativ erfolgen. Beispielsweise wird bei einer frischen und neuen Batterie lediglich die temperaturabhängige Einstellung des Arbeitspunktes gewählt. Bei einer älteren Batterie hingegen wird die alterungsabhängige Einstellung hinzugefügt oder alternativ berücksichtigt.

Der alterungsabhängige Korrekturfaktor kann in herkömmlicher Weise beispielsweise anhand eines modellbasierten Schätzverfahrens für die Kapazität und Leistungsfähigkeit der Batterie bestimmt werden. Darüber hinaus wird der Alterungszustand der Batterie bestimmt und mit den gespeicherten Werten einer frischen Batterie vergleichen.

Es wird bei Unterschreiten des angepassten Sollwerts für den Ladezustand durch den aktuellen Ladezustandswert zweckmäßigerweise eine Ausgleichsladung durchgeführt. Nach erfolgter Ausgleichsladung wird der aktuelle Ladezustandswert erneut bestimmt. Unterschreitet dieser weiterhin den angepassten Sollwert für den Ladezustand, so wird geprüft, ob bei einer entsprechenden Anpassung des alterungsabhängigen Korrekturfaktors durch Erhöhung um einen Wert größer 1 der Alterungszustand noch im funktionsfähigen Bereich liegt. Anderenfalls ist die Batterie auszutauschen.

Bei der erfindungsgemäßen Vorrichtung zur Durchführung des Verfahrens zur Steuerung des Arbeitspunktes ist in einer Ausgestaltungsform wenigstens ein Prozessor, der insbesondere Bestandteil eines Steuergeräts ist, vorgesehen, mittels dessen der Arbeitspunkt der Batterie über einen dynamisch anhand der Temperatur und/oder des Alterungszustands der Batterie nachgeführten Sollwert für den Ladezustand fortlaufend einstellbar ist.

Die mit der Erfindung erzielten Vorteile bestehen insbesondere darin, dass zusätzlich zur herkömmlichen Bestimmung des Ladezustands beispielsweise über Strom- und Spannungsmessungen der Ladezustand temperaturabhängig und alterungsabhängig nachgeführt, d.h. angepasst, wird. Eine derartige Nachführung des Ladezustands der Batterie über Temperatur und Alterung ergibt eine deutliche Lebens- und Gebrauchsverlängerung der Batterie und eine optimale Ausnutzung von verfügbarer Zeit und Leistung für den Betrieb eines Fahrzeugs, insbesondere dem elektrischen Fahrbetrieb eines Hybridfahrzeugs. Dabei wird der Ladezustand dynamisch als Funktion der Temperatur und der Alterung der Batterie auf einen aktualisierten und optimalen Arbeitspunkt nachgeführt. Der aktualisierte Arbeitspunkt ermöglicht insbesondere die im Hybridbetrieb eines Hybridfahrzeugs typischen Funktionen wie "Boosten" oder "Rekuperieren" oder "Laden" der Batterie bzw. "Stromentnahme" aus der Batterie mit einer für die Batterie hohen Lebensdauer und hohen Verfügbarkeit.

Ausführungsbeispiele der Erfindung werden anhand einer Zeichnung näher erläutert. Darin zeigen:

Fig. 1    schematisch eine Vorrichtung zur Steuerung des Ar- beitspunktes einer Batterie in Abhängigkeit von der Temperatur und/oder vom Alterungszustand der Batte- rie,

Fig. 2    eine erste temperaturabhängige Kennlinie zur Vorgabe eines Sollwerts für den Ladezustand der Batterie, und

Fig. 3    eine zweite alterungsabhängige Kennlinie zur Vorgabe eines Korrekturwertes für den Ladezustandswert im Ar- beitspunkt in Abhängigkeit vom Alterungszustand der Batterie.

Einander entsprechende Teile sind in allen Figuren mit den gleichen Bezugszeichen versehen.

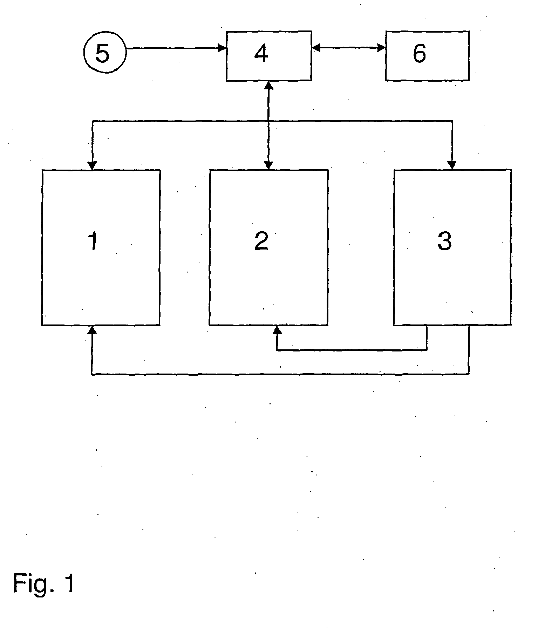

Figur 1 zeiat eine Vorrichtung zur Steuerung des Arbeitspunktes einer Batterie 1 für ein Fahrzeug. Bei der Batterie 1 kann es sich um eine Batterie für den Einsatz in einem Energiespeicher für ein Hybridfahrzeug handeln, im Folgenden auch Traktionsbatterie genannt. Als Traktionsbatterie wird beispielsweise eine Nickel-Metall-Hydrid-Batterie oder eine Lithium-Ionen-Batterie eingesetzt. Darüber hinaus kann eine weitere Sekundärbatterie 2 in Form einer Bleisäurebatterie vorgesehen sein. Über einen Generator 3 werden die Batterien 1 und 2 während der Fahrt geladen.

Zur Steuerung der Batterien 1 und 2 umfasst die Vorrichtung ein steuergerät 4, beispielsweise ein Batteriesteuergerät oder ein Bordnetzsteuergerät, das mit der Batterie 1 und der Sekundärbatterie 2 sowie dem Generator 3 verbunden ist. Mittels des Steuergeräts 4 werden als Parameter der Batterie 1 und der Sekundärbatterie 2 deren Ladezustand SoC beispielsweise anhand von Spannungs- und/oder Strom- und/oder Temperaturmessungen erfasst.

Darüber hinaus wird mittels eines Temperatursensors 5 als Temperatur T die Umgebungstemperatur erfasst. Alternativ oder zusätzlich kann als Temperatur T auch die jeweilige Batterie- oder Zellentemperatur erfasst werden.

Ferner sind zur Bestimmung des Alterungszustands SoH der Batterie 1 bzw. 2 Daten erforderlich, begründet durch z. B. Oberflächenpassivierung der Elektroden der Batterie, schleichende Austrocknung der Batteriezellen, Kontaktverluste und durch diese Vorgänge bedingte Erhöhung von Zellimpedanzen sowie Abnahme der Batteriekapazität bezogen auf die gleiche Entladeschlussspannung. Diese Daten können erfasst und bei der Bestimmung des Alterungszustands SoH beispielsweise mittels eines modelbasierten Schätzverfahrens berücksichtigt werden. Auch können insbesondere bei NiMH-Batterien Ladezustandsabweichungen einzelner Batteriezellen innerhalb einer Serienschaltung berücksichtigt werden, wobei eine durch Ausgleichsladung bewirkte Aufhebung der Abweichungen ebenso erfasst und bewertet wird.

Zur Berücksichtigung weiterer fahrzeugrelevanter Parameter, z. B. der Fahrzeuggeschwindigkeit, kann das Steuergerät 4 beispielsweise mit anderen Steuergeräten 6, Bremssteuergerät, verbunden sein.

Im herkömmlichen Betrieb eines Fahrzeugs wird die Bordnetz-Batterie in modernen Fahrzeugen für eine ausreichende Versorgung der elektrischen Verbraucher, wie Zündung, Kraftstoffeinspritzung, Beleuchtung, Heizung, Klimaanlage, Bremsen fortlaufend auf ihren Ladezustand SoC überwacht. Im Normalbetrieb der Traktionsbatterie 1, z. B.

einer Nickel-Metall-Hydrid-Batterie, soll der Ladezustand SoC in einem Ladezustandsbereich zwischen 50 % und 60 % für eine frische Batterie liegen.

Erfindungsgemäß ist vorgesehen, nicht nur den aktuellen Ladezustand SoC fortlaufend zu erfassen, sondern auch den optimalen Arbeitspunkt AP der Batterie 1 mittels eines Sollwerts $SoC_{soll}$ für den Ladezustand SoC derart einzustellen, dass die Temperatur T und/oder der Alterungszustand SoH der Batterie 1 berücksichtigt wird.

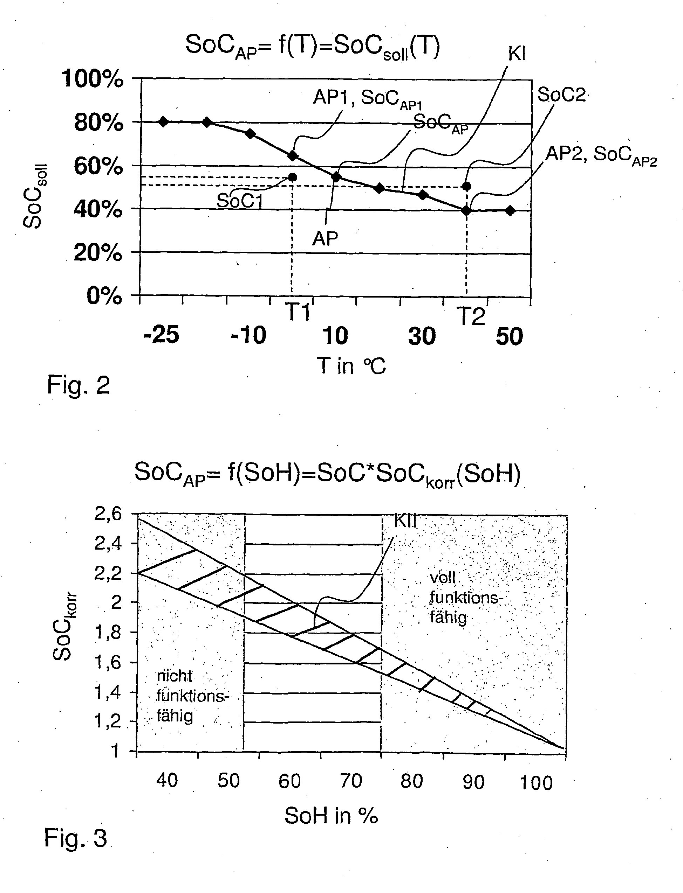

Hierzu wird der Sollwert $SoC_{soll}$ für den Ladezustand SoC fortlaufend anhand einer ersten, temperaturabhängigen Kennlinie KI vorgegeben, die in Figur 2 gezeigt ist. Dabei wird der Sollwert $SoC_{soll}$ für den Ladezustand SoC fortlaufend anhand der aktuellen Temperatur T nachgeführt gemäß der Beziehung [1].

Kommt es im Fahrbetrieb zu einem niedrigen Ladezustand SoC1 bei einer niedrigen Temperatur T1, so wird durch den vorgegebenen, temperaturabhängig nachgeführten Sollwert $SoC_{AP1}$ für den Ladezustand SoC1 mittels des Steuergeräts 4 ein entsprechender Arbeitspunkt AP1 eingestellt, indem eine Ladung der Batterie 1 bewirkt und ein Entladen der Batterie 1 durch den Generator 3 unterdrückt wird. Ist hingegen der Ladezustand SoC2 zu hoch bei einer hohen Temperatur T2, so wird durch die temperaturabhängige Nachführung des Sollwerts $SOC_{AP2}$ für den Ladezustand SoC2 der zugehörige Arbeitspunkt AP2 entsprechend eingestellt, indem mittels des Steuergeräts 4 ein Entladen der Batterie 1 beispielsweise durch den Generator 3 bewirkt wird.

Darüber hinaus kann zur Berücksichtigung des Alterungszustands SoH der Batterie 1 eine zweite alterungsabhängige Kennlinie KII zur Einstellung des jeweiligen Arbeitspunktes AP der Batterie 1 herangezogen werden. Die zweite Kennlinie II, die in Figur 3 näher dargestellt ist, dient dabei der Ermittlung eines alterungsabhängigen Korrekturfaktors $SoC_{korr}$ für den Ladezustand SoC. Der alterungsabhängige Korrekturfaktor $SoC_{korr}$ ergibt sich als Funktion des ermittelten Alterungszustands SoH der Batterie 1. Der Alterungszustand SoH wird in herkömmlicher Weise beispielsweise über entsprechende Algorithmen, z. B. modellbasierten Schätzverfahren für die Bestimmung der Leistungsfähigkeit der Batterie, insbesondere deren Verfügbarkeit oder Funktionsfähigkeit, ermittelt. Ist die Batterie 1 im vollfunktionsfähigen Alterungszustand SoH von größer 70 % bzw. im beschränkt funktionsfähigen Alterungszustand SoH von 50 % bis 70 %, so wird der Korrekturfaktor $SoC_{korr}$ bei der Einstellung des aktuellen Arbeitspunktes AP der Batterie 1 berücksichtigt. Im beschränkt funktionsfähigen Alterungszustand wird eine Ausgleichsladung im Falle einer NiMH-Batterie empfohlen und danach der Alterungszustand SoH neu ermittelt. Ist die Batterie 1 im nicht funktionsfähigen Alterungszustand SoH, so wird ein Austausch der Batterie 1 ausgegeben.

Bei der Ermittlung des Alterungszustands SoH werden im Falle einer NiMH-Batterie darüber hinaus elektrochemische Betriebs-und Alterungsvorgänge in folgender Weise differenziert berücksichtigt und unterschieden in irreversible und reversible Vorgänge. Als irreversible Vorgänge werden mittels des Korrekturfaktors $SoC_{korr}$ beispielsweise Oberflächenpassivierung der Elektroden, schleichende Austrocknung der Zelle, Kontaktverluste und durch diese bedingte Erhöhungen der Zellimpedanzen sowie Abnahme der Kapazität bezogen auf gleiche Entladeschlussspannung berücksichtigt. Als reversible Vorgänge werden beispielsweise Abweichungen von Zellen innerhalb einer Serienschaltung berücksichtigt. Abhängig davon wird mittels des Steuergeräts 4 im Falle einer NiMH-Batterie eine Ausgleichsladung der Batterie 1 während der Fahrt oder beim nächsten Halt oder beim nächsten Service empfohlen und gegebenenfalls aktiviert. Wird durch die Ausgleichsladung der Alterungszustand SoH auf den vorgegebenen Wert, beispielsweise 100 % für volle Funktionsfähigkeit nicht erreicht, so wird mittels des Korrekturfaktors $SoC_{korr}$ der Arbeitspunkt AP angehoben.

Je nach Einstellung und Zustand der Batterie 1 kann der Arbeitspunkt AP nur anhand der ersten temperaturabhängigen Kennlinie KI oder nur anhand der zweiten alterungsabhängigen Kennlinie KII oder anhand von beiden Kennlinien KI und KII gemäß den Beziehungen [1] bis [3] eingestellt werden, indem der Sollwert $SoC_{AP}$ entsprechend temperaturabhängig und/oder alterungsabhängig nachgeführt wird.

Handelt es sich um eine frische und neue Batterie 1 so wird lediglich die temperaturabhängige Kennlinie KI zur Einstellung des Arbeitspunkts AP herangezogen. Bei einer älteren Batterie 1 und normalen Umgebungstemperaturen wird hingegen lediglich die alterungsabhängige Kennlinie KII zur Einstellung des Arbeitspunktes AP herangezogen.

Die beschriebene Berücksichtigung von Alterungszustand SoH und Temperatur T anhand von Kennlinien KII bzw. KI zum Nachführen des Sollwerts $SoC_{AP}$ für den Ladezustand ermöglicht eine deutliche Verlängerung der Betriebsdauer der Batterie 1.

Bezugszeichenliste

1 Batterie
2 Sekundärbatterie
3 Generator
4 Steuergerät
5 Temperatursensor
6 Weitere Steuergeräte

AP   Arbeitspunkt

KI, KII  Kennlinien

SoC   Ladezustand

$SOC_{soll}$ Sollwert für den Ladezustand

$Soc_{ist}$ Istwert für den Ladezustand

$SoC_{korr}$ Korrekturfaktor

SoH   Alterungszustand

T    Temperatur

**Patentansprüche**

1. Verfahren zur Steuerung des Arbeitspunktes (AP, AP1, AP2) einer Batterie (1), insbesondere einer Lithium-Ionen-Batterie, einer Nickel-Metall-Hydrid-Batterie, einer Lithium-Polymer-Batterie, bei dem als eine den Arbeitspunkt (AP1, AP2) der Batterie (1) bestimmenden Zustandsgröße der Ladezustand (SoC1, SoC2) der Batterie (1) erfasst wird, wobei der aktuelle Arbeitspunkt (AP1, AP2) mittels eines zugehörigen, in Abhängigkeit von der Temperatur (T) und/oder vom Alterungszustand (SoH) fortlaufend angepassten Sollwerts ($SoC_{AP1}$, $SoC_{AP2}$) für den Ladezustand (SoC1, SoC2) eingestellt wird.

2. Verfahren nach Anspruch 1, bei dem der aktuelle Sollwert ($SoC_{AP1}$, $SoC_{AP2}$) für den Ladezustand (SoC1, SoC2) anhand einer vorgegebenen ersten, insbesondere temperaturabhängigen Kennlinie (KI) angepasst wird.

3. Verfahren nach Anspruch 1 oder 2, bei dem der aktuelle Ladezustand (SoC1, SoC2) der Batterie (1) anhand einer insbesondere kontinuierlichen Messung des Batteriestroms und der aufgenommenen und/oder entnommenen Ladung ermittelt wird.

4. Verfahren nach einem der vorhergehenden Ansprüche, bei dem der aktuelle Ladezustand (SoC1, SoC2) anhand eines Ruhespannungsmessverfahrens und/oder eines modellbasierten Schätzverfahrens bestimmt wird.

5. Verfahren nach einem der vorhergehenden Ansprüche, bei dem als Temperatur (T) die Umgebungstemperatur und/oder die Batterietemperatur, insbesondere die Zellentemperatur, erfasst werden bzw. wird.

6. Verfahren nach einem der vorhergehenden Ansprüche, bei dem der aktuelle Sollwert ($SoC_{AP1}$, $SoC_{AP2}$) für den Ladezustand (SoC1, SoC2) mittels eines alterungsabhängigen Korrekturfaktor ($SoC_{korr}$) und anhand einer vorgegebenen zweiten, insbesondere alterungsabhängigen Kennlinie (KII) angepasst wird.

7. Verfahren nach Anspruch 6, bei dem der alterungsabhängige Korrekturfaktor ($Soc_{korr}$) anhand einer modellbasierten Schätzverfahren für die Kapazität und Leistungsfähigkeit der Batterie (1) bestimmt wird.

8. Verfahren nach einem der vorhergehenden Ansprüche, bei dem der Alterungszustand (SoH) der Batterie (1) anhand eines Spannungsmessverfahrens, eines Strommessverfahrens und/oder eines modellbasierten Schätzverfahrens bestimmt wird.

9. Verfahren nach einem der vorhergehenden Ansprüche, bei dem bei Unterschreiten des angepassten Sollwerts ($SoC_{AP2}$) für den Ladezustand (SoC2) durch den aktuellen Ladezustandswert eine Ausgleichsladung durchgeführt wird.

10. Verfahren nach Anspruch 9, bei dem nach erfolgter Ausgleichsladung der alterungsabhängige Korrekturfaktor ($SoC_{korr}$) auf einen Wert größer als 1 gesetzt wird.

11. Vorrichtung zur Durchführung eines Verfahrens zur Steuerung des Arbeitspunktes (AP, AP1, AP2) einer Batterie (1), insbesondere einer Lithium-Ionen-Batterie, einer Nickel-Metall-Hydrid-Batterie, einer Lithium-Polymer-Batterie, umfassend wenigstens einen Prozessor, der insbesondere Bestandteil eines Steuergeräts (4) ist, mittels dessen der Arbeitspunkt (AP1, AP2) der Batterie (1) mittels eines dynamisch anhand der Temperatur (T) und/oder des Alterungszustands (SoH) der Batterie (1) nachgeführten Sollwerts (SoC$_{AP1}$, SbC$_{AP2}$) für den Ladezustand (SOC1, SoC2) fortlaufend einstellbar ist.

## Claims

1. A method for controlling the operating point (AP, AP1, AP2) of a battery (1), in particular a lithium ion battery, a nickel metal hydride battery, a lithium polymer battery, in which as a state variable which determines the operating point (AP1, AP2) of the battery (1), the charge state (SoC1, SoC2) of the battery (1) is recorded, wherein the current operating point (AP1, AP2) is set by means of a corresponding set value (SoC$_{AP1}$, Soc$_{AP2}$) which is continuously adapted depending on the temperature (T) and/or the age state (SoH) for the charge state (SoC1, SoC2).

2. A method according to claim 1, in which the current set value (SoC$_{AP1}$, Soc$_{AP2}$) is adapted on the basis of a specified first, in particular, temperature-dependent characteristic curve (KI).

3. A method according to either of claims 1 or 2, in which the current charge state (SoC1, SoC2) of the battery (1) is determined on the basis of a measurement, which is in particular continuous, of the battery current and the charge which is received and/or removed.

4. A method according to any one of the preceding claims, in which the current charge state (SoC1, SoC2) is determined on the basis of an open-circuit voltage measurement method and/or a model-based estimation method.

5. A method according to any one of the preceding claims, in which the ambient temperature and/or the battery temperature, in particular the cell temperature, is or are recorded as the temperature (T).

6. A method according to any one of the preceding claims, in which the current set value (SoC$_{AP1}$, Soc$_{AP2}$) for the charge state (SoC1, SoC2) is adapted by means of an age-dependent correction factor (SoC$_{korr}$) and on the basis of a specified second, in particular age-dependent characteristic curve (KII).

7. A method according to claim 6, in which the age-dependent correction factor (SoC$_{korr}$) is determined on the basis of a model-based estimation method for the capacity and performance of the battery (1).

8. A method according to any one of the preceding claims, in which the age state (SoH) of the battery (1) is determined on the basis of a voltage measuring method, a current measuring method and/or a model-based estimation method.

9. A method according to any one of the preceding claims, in which when the adapted set value (Soc$_{AP2}$) for the charge state (SoC2) is not reached by the current charge state value, a compensation charge is conducted.

10. A method according to claim 9, in which following a compensation charge, the age-dependent correction factor (SoC$_{korr}$) is set to a value greater than 1.

11. A device for implementing a method for controlling the operating point (AP, AP1, AP2) of a battery (1), in particular a lithium ion battery, a nickel metal hydride battery, a lithium polymer battery, comprising at least one processor, which is in particular a component of a control device (4), by means of which the operating point (AP1, AP2) of the battery (1) can be continuously set by means of a dynamically updated set value (SoC$_{AP1}$, Soc$_{AP2}$) for the charge state (SoC2, SoC2) on the basis of the temperature (T) and/or the age state (SoH) of the battery (1).

## Revendications

1. Procédé pour le pilotage du point de fonctionnement (AP, AP1, AP2) d'une batterie (1), en particulier d'une batterie lithium-ion, d'une batterie nickel-métal-hydrure, d'une batterie lithium-polymère, avec lequel l'état de charge (SoC1, SoC2) de la batterie (1) est saisi comme une grandeur d'état définissant le point de fonctionnement (AP1, AP2) de la batterie (1), le point de fonctionnement actuel (AP1, AP2) étant réglé pour l'état de charge (SoC1, SoC2) au moyen d'une valeur prescrite (SoC$_{AP1}$, SoC$_{AP2}$) correspondante ajustée continuellement en fonction de la température (T) et/ou de l'état de vieillissement (SoH).

2. Procédé selon la revendication 1, avec lequel la valeur prescrite actuelle ($SoC_{AP1}$, $SoC_{AP2}$) est ajustée pour l'état de charge (SoC1, SoC2) au moyen d'une première courbe caractéristique (KI) spécifiée, en particulier fonction de la température.

3. Procédé selon la revendication 1 ou 2, avec lequel l'état de charge (SoC1, SoC2) actuel de la batterie (1) est déterminé au moyen d'une mesure en particulier continuelle du courant de batterie et de la charge reçue et/ou prélevée.

4. Procédé selon l'une des revendications précédentes, avec lequel l'état de charge (SoC1, SoC2) actuel est défini au moyen d'un procédé de mesure de tension de repos et/ou d'un procédé d'évaluation à base de modèles.

5. Procédé selon l'une des revendications précédentes, avec lequel la température ambiante et/ou la température de la batterie, en particulier la température des cellules est saisie ou sont saisies comme température (T).

6. Procédé selon l'une des revendications précédentes, avec lequel la valeur prescrite actuelle ($SoC_{AP1}$, $SoC_{Ap2}$) est ajustée pour l'état de charge (SoC1, SoC2) au moyen d'un facteur de correction ($SoC_{korr}$) fonction du vieillissement et au moyen d'une deuxième courbe caractéristique (KII) spécifiée, en particulier fonction du vieillissement.

7. Procédé selon la revendication 6, avec lequel le facteur de correction ($SoC_{korr}$) fonction du vieillissement est défini pour la capacité et la performance de la batterie (1) au moyen d'un procédé d'évaluation à base de modèles.

8. Procédé selon l'une des revendications précédentes, avec lequel l'état de vieillissement (SoH) de la batterie (1) est défini au moyen d'un procédé de mesure de tension, d'un procédé de mesure de courant et/ou d'un procédé d'évaluation à base de modèles.

9. Procédé selon l'une des revendications précédentes, avec lequel une charge de compensation est effectuée lorsque la valeur d'état de charge actuelle passe sous la valeur prescrite ajustée ($SoC_{AP2}$) pour l'état de charge (SoC2).

10. Procédé selon la revendication 9, avec lequel le facteur de correction fonction du vieillissement ($SoC_{korr}$) est fixé à une valeur supérieure à 1, une fois la charge de compensation effectuée.

11. Dispositif pour l'exécution d'un procédé pour le pilotage du point de fonctionnement (AP, AP1, AP2) d'une batterie (1), en particulier d'une batterie lithium-ion, d'une batterie nickel-métal-hydrure, d'une batterie lithium-polymère, comprenant au moins un processeur, lequel est en particulier composant d'un dispositif de commande (4), au moyen duquel le point de fonctionnement (AP1, AP2) de la batterie (1) est réglable continuellement pour l'état de charge (SOCI, SoC2) au moyen d'une valeur prescrite ($SoC_{AP1}$, $SoC_{AP2}$) actualisée dynamiquement à l'aide de la température (T) et/ou de l'état de vieillissement (SoH) de la batterie (1).

Fig. 1

$$SoC_{AP} = f(T) = SoC_{soll}(T)$$

Fig. 2

$$SoC_{AP} = f(SoH) = SoC * SoC_{korr}(SoH)$$

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19918529 B4
- EP 1324062 A2